Europäisches Patentamt

**European Patent Office**

**Office européen des brevets**

(19)

(11) Veröffentlichungsnummer: **0 001 985**
**A1**

# (12) EUROPÄISCHE PATENTANMELDUNG

(21) Anmeldenummer: **78101193.7**

(22) Anmeldetag: **23.10.78**

(51) Int. Cl.²: **H 01 J 37/18, H 01 J 37/30**

(30) Priorität: **01.11.77 US 847645**

(43) Veröffentlichungstag der Anmeldung: **30.05.79**
**Patentblatt 79/11**

(84) Benannte Vertragsstaaten: **DE FR GB**

(71) Anmelder: **International Business Machines Corporation, Armonk, N.Y. 10504 (US)**

(72) Erfinder: **Arndt, Herbert Lorenz, Jr., 2 Pattie Place, Wappingers Falls NY 12590 (US)**
Erfinder: **Keller, John Howard, 7 Dutchess Court, Newburgh, NY 12550 (US)**
Erfinder: **McKenna, Charles Michael, 7 Wedgewood Road, Fishkill, NY 12524 (US)**
Erfinder: **Winnard, James Robert, 8 Bellmore Drive, Poughkeepsie, NY 12603 (US)**

(74) Vertreter: **Böhmer, Hans Erich, Dipl.-Ing., Schönaicher Strasse 220, D-7030 Böblingen (DE)**

(54) **Ionen-Implantationsvorrichtung mit einer Vorrichtung zur Aufrechterhaltung des Vakuums.**

(57) In einer Ionen-Implantationsvorrichtung zum Beschießen einer Halbleiterscheibe mit einem Ionenstrahl werden Mittel bereitgestellt, um den Strahl und die Auffangelektrode oder die zu beschießende Halbleiterscheibe unter einem Vakuum von $2 \times 10^{-4}$ Torr oder geringeren Drücken zu halten. Die Vorrichtung enthält einen Massenseparator (20), d. h. einen Analysiermagneten, der ausgewählte Ionen zur Bildung des gewünschten Strahls mit einer Flugbahn längs einer ausgewählten Achse liefert. Die Auffangelektrode (26, 33) ist längs dieser ausgewählten Achse angeordnet. Ferner ist ein sich von dem Massenseparator (20) nach der Auffangelektrode (26, 33) erstreckendes Gehäuse (25) vorgesehen und umschließt die innerhalb einer Kammer liegende Achse und die Auffangelektrode (26, 33), wobei innerhalb dieser Kammer quer zu der Achse den Strahl formende Mittel mit einer längs der Achse angeordneten Blende (23, 27) oder Öffnung vorgesehen sind, die den Durchtritt eines ausgewählten Teils des Ionenstrahls nach der Auffangelektrode (26, 33) gestatten. Eine Vakuumpumpe (28) ist über eine Öffnung in dem Gehäuse mit der Kammer verbunden und liegt quer zu den Strahl formenden Mitteln, so daß Gas von beiden Seiten dieser den Strahl formenden Mittel abgezogen werden kann.

- 1 -

Ionen-Implantationsvorrichtung mit einer Vorrichtung für eine verbesserte Aufrechterhaltung des Vakuums

Die Erfindung betrifft eine Vorrichtung zur Aufrechterhaltung eines Vakuums in einer Ionen-Implantationsvorrichtung zum Beschießen einer Auffangelektrode mit einem Ionenstrahl, insbesondere eine Vorrichtung, durch die bestimmte, unter Atmosphärendruck liegende Drücke, wie zum Beispiel hohe Unterdrücke, in dem System wirkungsvoll aufrechterhalten werden können. Bei Ionen-Implantationsvorrichtungen, bei denen Halbleiterscheiben in die Elektrodenkammer eingeführt und dort in bezug auf die Strahlachse angeordnet und wieder aus dieser Kammer entnommen werden, ist es wichtig, daß die Auspumpzeiten, d. h. die Zeiten, die erforderlich sind, um die Vorrichtung bis zum Betriebsvakuum abzupumpen, so kurz als möglich gehalten werden, und daß dieses Abpumpen so wirkungsvoll wie möglich durchgeführt wird. Zum Erzielen sehr kurzer Abpumpzeiten verwenden übliche Ionen-Implantationsvorrichtungen eine Anzahl von Vakuumpumpen, die längs der Strahlachse und an der Elektrodenkammer angeordnet sind. Unter Strahlachse und Elektrodenkammer

FI 977 C21

soll dabei der Abschnitt der Ionen-Implantationsvorrichtung verstanden werden, der den Massenseparator oder den Analysiermagneten enthält, oder jenseits des Massenseparators oder Analysiermagneten liegt, wo dann die für die Bombardierung der Auffangelektrode ausgewählten Ionen einer Bahn längs der Strahlachse folgen. Aus Gründen der Wirtschaftlichkeit, Zuverlässigkeit und des gedrängten Aufbaus ist die Verwendung einer Anzahl von Vakuumpumpen nicht besonders wünschenswert.

Während es im allgemeinen sehr erwünscht ist, die Anzahl der Vakuumpumpen längs der Strahllinie zu verringern, so hat man doch bei derzeit gebräuchlichen Ionen-Implantationssystemen festgestellt, daß dies nur schwierig zu erreichen ist, da in diesem Teil des Systems den Strahl definierende Mittel mit sehr kleinen Öffnungen verwendet werden, so daß dadurch die Gasströmung in diesem Abschnitt in Richtung auf nur eine einzige Pumpe sehr stark erschwert wird.

## Gesamtdarstellung der Erfindung

Aufgabe der Erfindung ist es, eine Ionen-Beschießungsanlage zu schaffen, die eine vereinfachte Anordnung zum Auspumpen der Vorrichtung auf Vakuumdrücke von $2 \times 10^{-4}$ Torr = $2,666 \times 10^{-4}$ mbar oder weniger aufweist. Dies soll insbesondere durch die Verwendung nur einer einzigen Vakuumpumpe für diejenigen Teile der Vorrichtung erreicht werden, die den Ionenstrahl und die Auffangelektrode bzw. den zu beschießenden Gegenstand enthält. Insbesondere ist dabei die Erfindung in dem Fall von Bedeutung, in dem die Ionen-Implantationsvorrichtung eine den Ionenstrahl definierende Struktur mit nur ganz kleinen Öffnungen in Blenden in der Strahlachse aufweist, die für das Gas einen sehr hohen Strömungswiderstand bilden,

FI 977 021

wobei gerade in diesem Fall in den Abschnitten des Ionenstrahls und der Auffangelektrode der Vorrichtung mit nur einer einzigen Pumpe ein Vakuum erzielt werden kann.

Die der Erfindung zugrunde liegende Aufgabe wird in einer Ionen-Implantationsvorrichtung zum Beschießen einer Elektrode mit einem Strahl ausgewählter Ionen mit einem Aufbau zur Aufrechterhaltung des Vakuums in der Vorrichtung gelöst. Dieser Aufbau besteht aus einem Gehäuse, das die Strahlachse und die Auffangelektrode, die längs der Strahlachse innerhalb einer Kammer angeordnet ist und eine quer zur Strahlachse den Strahl formende Lochblende innerhalb der Kammer aufweist, die die Strömung des Gases durch die Kammer behindern, wobei die den Strahl formende Blende eine auf der Achse angeordnete Öffnung aufweist, die den Durchtritt eines ausgewählten Teils eines Strahls nach der Auffangelektrode gestattet, wobei eine Vakuumpumpe über einer Öff-nung in dem Gehäuse in der Weise zu beiden Seiten der den Strahl formenden Lochblende angeordnet ist, daß beim Abpumpen der Kammer das Gas von beiden Seiten der den Strahl formenden Lochblende abgesaugt werden kann.

Es sei darauf hingewiesen, daß die den Strahl formende Lochblende, die die Strömung des Gases durch die Kammer behindern kann, eine quer zu der Kammer angeordnete Trennplatte längs der Strahlachse sein kann, und damit die ausgewählten Ionen aussondert und nach der Auffangelektrode durchläßt, während die Ionen mit anderen Bahnen abgeblockt werden (das soll noch näher erläutert werden). Andererseits kann die den Strahl formende Blende, die das Strömen von Gas behindert, im ein-fachsten Fall die Blende eines Faradayschen Käfigs

oder irgendeine andere den Strahlstrom messende Vorrichtung sein, die die Strömung des Gases durch die Kammer behindert. Soll die Anordnung in Verbindung mit einem Massenseparator verwendet werden, dann besteht die erfindungsgemäße Anordnung aus einem Massenseparator, der die ausgewählten Ionen längs einer ausgewählten Achse über eine Bahn leitet, wobei die Auffangelektrode längs dieser ausgewählten Achse angeordnet ist, mit einem von dem Massenseparator sich bis zu der Auffangelektrode erstreckenden Gehäuse, das die Achse und die Auffangelektrode innerhalb einer Kammer umgibt, aus einer innerhalb der Kammer quer zur ausgewählten Achse zwischen dem Massenseparator und der Auffangelektrode liegenden Platte, die in der Achse eine Öffnung aufweist und damit den aus ausgewählten Ionen bestehenden Strahl in Richtung auf die Auffangelektrode durchläßt, während Ionen mit anderen Flugbahnen abgeblockt werden, und aus einer Vakuumpumpe, die mit der Kammer über eine Öffnung in dem Gehäuse angeschlossen ist, welche zu beiden Seiten der den Strahl formenden Platte vorgesehen ist, so daß die Vakuumpumpe Gas von beiden Seiten dieser Platte abzieht. Mit dieser Anordnung ist es selbst dann, wenn die Öffnung in der den Strahl formenden Platte sehr klein ist, mit einer einzigen Vakuumpumpe möglich, effektiv zu arbeiten, da die Pumpe über eine zu beiden Seiten der den Strahl formenden Platte liegenden Öffnung angeschlossen ist und damit unabhängig von der Blendenöffnung in der den Strahl formenden Platte beim Auspumpen das Gas von beiden Seiten dieser Platte absaugt.

Obgleich die den Strahl formende Platte als erste oder sogar als einzige Blende für den Strahl wirken könnte, so ist es doch bei Vorrichtungen für Ionen-

Beschuß üblich und vorteilhaft, mehr als eine den Strahl formende Blende zwischen dieser Platte und der Auffangelektrode vorzusehen, um damit die Auffangelektrode von dem Strahleingang zu trennen, damit zu beschießende Auffangelektroden oder Halbleiterscheiben leicht eingebracht und abgezogen werden können.(Vergleiche US-Patent 3 983 402 mit einem typischen Beispiel einer solchen Vorrichtung.) Gemäß der vorliegenden Erfindung sind daher eine oder mehrere solcher den Strahl formender Elektroden in Verbindung mit einer den Strahl formenden Platte vorgesehen, die den Wirkungsgrad der unter Unterdruck stehenden oder mit Vakuumpumpe arbeitenden Anordnung gemäß der Erfindung nicht beeinträchtigt. Mindestens eine ringförmige, den Strahl definierende Elektrode ist über der Achse zwischen der den Strahl formenden Platte und der Auffangelektrode mit Abstand von dem Gehäuse angeordnet, und weist eine Öffnung in der Achse auf und begrenzt damit den in Richtung auf die Auffangelektrode laufenden Ionenstrahl auf ausgewählte Ionen in einer vorbestimmten Form.

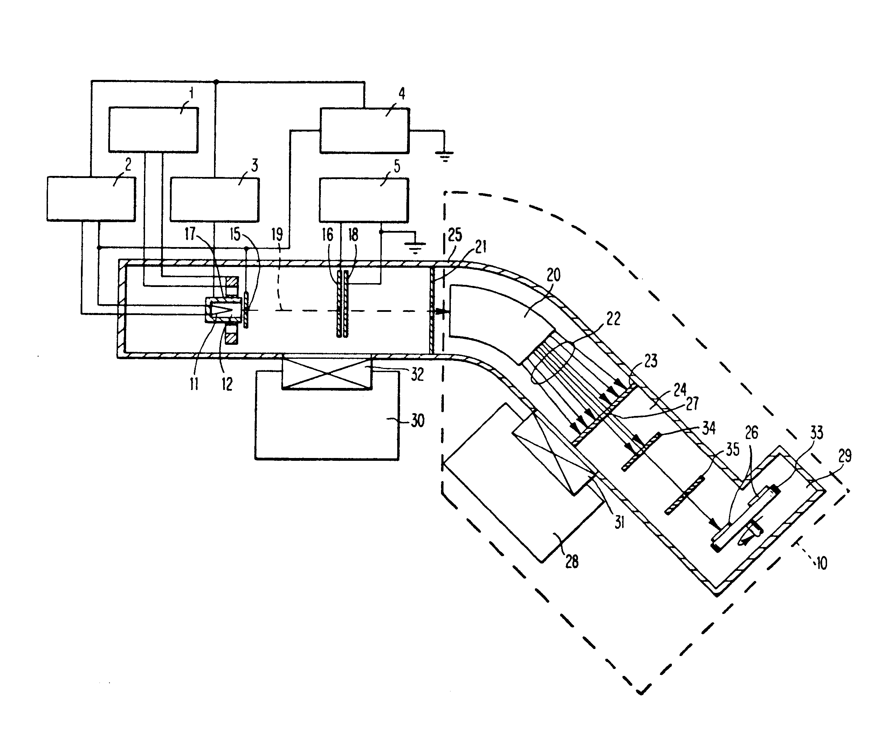

Die Erfindung wird nunmehr anhand eines Ausführungsbeispiels in Verbindung mit der beigefügten Zeichnung im einzelnen beschrieben.

Anhand der Zeichnung soll ein bevorzugtes Ausführungsbeispiel der erfindungsgemäß aufgebauten Vorrichtung beschrieben werden, durch das das Vakuum im Strahlengang und in der die Auffangelektrode aufnehmenden Kammer aufrechterhalten werden soll, wobei dieser Bereich durch eine gestrichelte Linie 10 umschrieben ist und sich auf eine sonst handelsübliche Ionen-Implantationsvorrichtung bezieht. Die Vorrichtung enthält eine Ionenquelle 12, die an sich jede Ionen mit hoher Dichte liefernde Ionenquelle sein kann, obgleich hier eine durch eine Heizspannungsquelle 2 geheizte mit Elektronenaufschlag arbeitende Ionenquelle dargestellt ist, die im oszillierenden Elektronen-Entladungsbetrieb arbeitet und ein an einer Solenoid-Spannungsquelle 1 angeschlossenes Solenoid aufweist. Ein Ionenstrahl wird über eine Blende 15, die an einer Extraktions-Spannungsquelle 4 angeschlossen ist, durch eine Extraktionselektrode 16 ausgeschleust. Die Extraktionselektrode 16, die auch als Beschleunigungselektrode bekannt ist, wird durch die Elektroden-Spannungsquelle 5 auf einem negativen Potential gehalten. Die Quellelektrode 17 wird durch die Anodenspannungsquelle 3 auf einem gegenüber der Heizwendel 11 positiven Potential gehalten. Außerdem ist eine Verzögerungselektrode 18 vorgesehen, die auf Erdpotential gehalten wird. Es sei darauf verwiesen, daß beim Betrieb der Vorrichtung durch den Fachmann die hier beschriebenen Vorspannungen auch geändert werden können.

Der durch die hier offenbarte Elektrodenanordnung ausgeschleuste, von der Ionenquelle stammende Ionenstrahl wird über einen Strahlengang 19 und eine Lochblende 21 nach einem Analysiermagneten 20 übertragen, der als Ionen-Separator durch Massenanalyse dient. Die Lochblende 21 ist dabei quer zur Strahlachse 19 und quer über die durch das Gehäuse 25 umschlossene Kammer von Innenwand zu Innenwand angeordnet.

Die besonderen Merkmale der Erfindung, die innerhalb des durch gestrichelte Umrandung 10 dargestellten Blocks der Zeichnung dargestellt sind, enthalten den Analysiermagneten 20, der eine Anzahl von Ionenstrahlen 22 erzeugt. Jeder dieser Ionenstrahlen durchläuft in Abhängigkeit von der jeweiligen Masse der diesen Strahl bildenden Ionen der entsprechenden Komponentenart eine unterschiedliche Bahn, wobei

FI 977 021

diese Ionen alle ursprünglich den dem Analysiermagneten 20 von der Ionenquelle zugeführten Ionenstrahl enthalten sind. Eine weitere Lochblende 23, die von Innenwand zu Innenwand quer zur Strahlengangkammer 24 innerhalb des Gehäuses 25 angeordnet ist, blendet die unerwünschten Ionen aus dem Ionenstrahl aus, der auf der hier als Auffangplatte wirkenden Halbleiterscheibe 26 auftreffen soll. Die Blendenöffnung 27 in der Lochblende 23 läßt damit die Ionen mit den erwünschten Ionenbahnen nach der als Auffangelektrode dienenden Halbleiterscheibe 26 durch. Mit dieser Anordnung kann die Vakuumpumpe 28 das Vakuum auf beiden Seiten des Strahlengangs der Kammer 24, der sich von der Lochblende 21 bis zur Lochblende 23 erstreckt, aufrechterhalten. Somit ist zusätzlich zur Vakuumpumpe 30, die das Vakuum am quellseitigen Ende der Ionen-Implantationsvorrichtung am anderen Ende der Lochblende 21 aufrechterhält, nur eine einzige Vakuumpumpe 28 erforderlich, um in der gesamten Ionen-Implantationsvorrichtung ein Vakuum aufrechtzuerhalten. Die Vakuumpumpen 28 und 30 stehen dabei mit den entsprechenden Teilen der Vorrichtung über Ventile 31 und 32 in Verbindung. In der die Auffangelektrode enthaltenden Kammer sind die Halbleiterscheiben 26 auf einem Träger 33 angebracht, der in der angegebenen Richtung rotiert und in Schwingungen versetzt wird, wie dies beispielsweise auch in den US-Patentschriften 3 778 626 und 3 983 402 beschrieben ist. Die Halbleiterscheiben können dabei auf den Träger in einfacher Weise durch eine Vorrichtung eingeführt und entnommen werden, wie sie beispielsweise in der US-Patentschrift 3 983 402 beschrieben ist. Längs der Achse oder des Strahlengangs sind weitere ringförmige Elektroden 34 und 35 vorgesehen, die weiter der genauen Auswahl der gewünschten Ionen dienen und die Bahn des aus den ausgewählten Ionen

FI 977 021

bestehenden Strahls auf einen Punkt oder Spalt sehr kleiner Abmessungen konzentrieren oder fokussieren, und zwar für eine Anwendung auf eine Halbleiterscheibe zur Durchführung eines Ionen-Beschusses oder für die Implantation von Ionen bei der Herstellung von integrierten Schaltungen.

Da die ringförmigen Elektroden relativ kleine Querschnittsabmessungen aufweisen und an den Innenwänden des Gehäuses 25 mit Hilfe von Sützen oder Klammern (nicht gezeigt) befestigt sind, so daß diese ringförmigen Elektroden von der Innenwand der Kammer im Gehäuse 25 einen Abstand aufweisen, können die ringförmigen Elektroden 34 und 35 wirksam der Strahlformung dienen, ohne dabei den Strömungswiderstand für Gas oder Luft in der Kammer während des Abpumpens durch die Vakuumpumpe 28 zu beeinträchtigen.

- 1 -

PATENTANSPRÜCHE

1. Ionen-Implantationsvorrichtung mit einem Massenseparator für die Abgabe ausgewählter Ionen längs einer in einer ausgewählten Achse liegenden Bahn nach einer auf dieser Achse angeordneten Auffangelektrode, einem sich von dem Massenseparator bis zur Auffangelektrode erstreckenden eine diese und die Achse einschließende Kammer bildenden Gehäuse, und einer zwischen Massenseparator und Auffangelektrode liegenden, sich quer zur Achse von Innenwand zu Innenwand in der Kammer erstreckenden Lochblende (23), die nur die ausgewählten Ionen nach der Auffangelektrode durch die Blendenöffnung durchläßt, die nicht ausgewählten Ionen jedoch zurückhält, und mit einer über ein Ventil (31) angekoppelten Vakuumpumpe (28), dadurch gekennzeichnet, daß die Vakuumpumpe (28) über eine zu beiden Seiten der durchgehenden Lochblende (23) angeordnete Öffnung in der Wand des Gehäuses angekoppelt ist.

2. Vorrichtung nach Anspruch 1, dadurch gekennzeichnet, daß die Lochblende (23) der Messung des Strahlstroms dient.

3. Vorrichtung nach Anspruch 1, dadurch gekennzeichnet, daß zwischen der Lochblende und der Auffangelektrode mindestens eine ringförmige, den Strahl formende Elektrode (34, 35) mit Abstand von der Innenwand des Gehäuses (25) quer zur Strahlachse angeordnet ist und damit den auf die Auffangelektrode gerichteten Strahl auf eine vorbestimmte Form begrenzt.

FI 977 021

0001985

4. Vorrichtung nach Anspruch 3, dadurch gekennzeichnet,
daß die Lochblende (23) für Gas praktisch undurchlässig ist.

FI 977 021

0001985

1/1

IM - EL 077 021

Europäisches
Patentamt

**EUROPÄISCHER RECHERCHENBERICHT**

0001985
Nummer der Anmeldung
EP 78 10 1193

| Kategorie | EINSCHLÄGIGE DOKUMENTE Kennzeichnung des Dokuments mit Angabe, soweit erforderlich, der maßgeblichen Teile | betrifft Anspruch |
|---|---|---|
| | DE - C - 902 757 (LICENTIA) * Seite 2, Zeilen 5-19,58-62; Figur; Ansprüche 4,5 * | 1,4 |
| | NUCLEAR INSTRUMENTS AND METHODS, Vol. 92, Nr. 4, 15. April 1971, Amsterdam, NL, P.J. CRACKNELL et al. "Use of low-energy accelerators for ion implantation", Seiten 465-469 * Seite 468, rechte Spalte, Absätze 1,2; Figur 4 * | 2 |
| | REVIEW OF SCIENTIFIC INSTRUMENTS, Vol. 44, Nr. 9, September 1973, New York, US, R.G. MUSKET et al. "UHV-Compatible collimator and faraday cup assembly", Seiten 1290-1292 * Seite 1290, linke Spalte, Absatz 1; rechte Spalte, letzte Absatz; Figur 1 * | 3 |
| A | US - A - 3 756 862 (J. AHN et al.) * Figur 5 * | 1,3 |

**KLASSIFIKATION DER ANMELDUNG (Int.Cl.²)**

H 01 J 37/18
37/30

**RECHERCHIERTE SACHGEBIETE (Int. Cl.²)**

H 01 J 37/18
37/30
39/34

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 12-02-1979 | BORMS |